# EUROPEAN PATENT APPLICATION

(11) **EP 1 435 688 A1**
(43) Date of publication of application: **07.07.2004**
(21) Application number: 01974828.4
(22) Date of filing: 12.10.2001
(51) Int. Cl.: H03G 3/20, H04J 13/04

(54) **AMPLIFIER APPARATUS AND RECEIVER**

(71) Applicant: MITSUBISHI DENKI KABUSHIKI KAISHA, Tokyo 100-8310 (JP)
(72) Inventor: YAMAGUCHI, Tatsuya Mitsubishi Denki K. K., Chiyoda-ku, Tokyo 100-8310 (JP); NAGANO, Hiroaki Mitsubishi Denki K. K., Chiyoda-ku, Tokyo 100-8310 (JP)
(74) Representative: Popp, Eugen, Dr.
(86) International application number: PCT/JP2001/008993
(87) International publication number: WO 2003/034588

(57) **Abstract**

The conventional amplifying device and receiver involve a problem that the gain varies excessively in amplifying a signal containing noise. Accordingly, an amplifying device and receiver of the invention comprise variable-gain amplifying means for amplifying and outputting an analog signal, detecting means for detecting a signal level of the analog signal, selecting means for selecting a relatively great signal level from the signal levels detected by the detecting means, and gain control means for controlling the gain in the variable-gain amplifying means on the basis of the signal level selected by the selecting means.

## Description

### TECHNICAL FIELD

This invention relates to an amplifying device for amplifying and outputting an analog signal and to a receiver for receiving, amplifying, A/D-converting and demodulating a signal spread by a spread-spectrum code sequence.

### BACKGROUND OF THE INVENTION

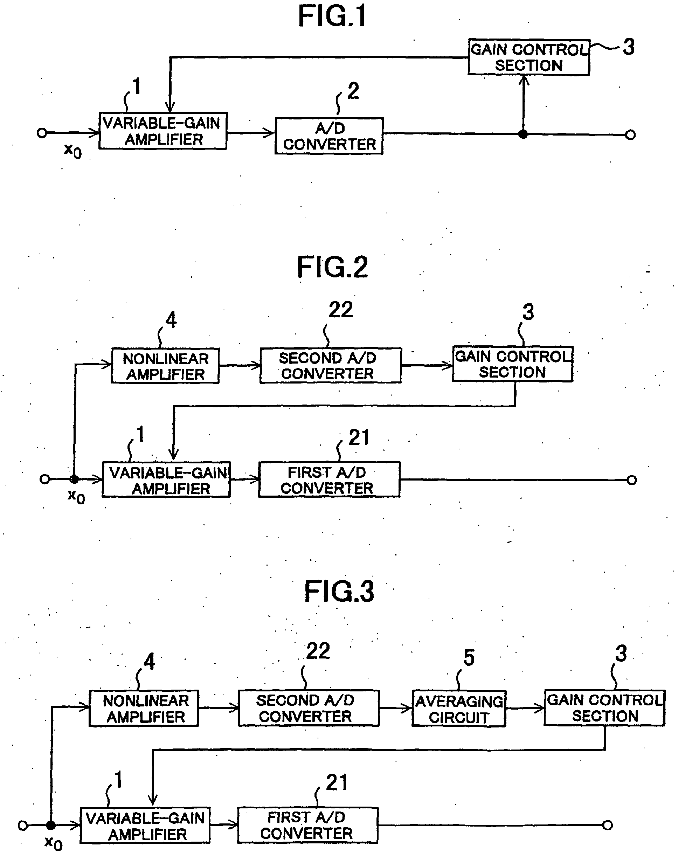

Fig. 1 is a configuration diagram exemplifying a basic configuration of a conventional amplifying device. In the figure, x₀ is an analog input signal, 1 is a variable-gain amplifier, 2 is an A/D converter and 3 is a gain control section. The variable-gain amplifier 1 amplifies an analog input signal x₀ and outputs it to the A/D converter 2. The A/D converter 2 A/D-converts the signal from the variable-gain amplifier 1 and outputs a digital signal. The gain control section 3 controls a gain in variable-gain amplifier 1 on the basis of the digital signal.

However, in the amplifying device shown in Fig. 1, in case a signal having a magnitude exceeding a conversion capability of the A/D converter 2 is input to the A/D converter 2, the output of the A/D converter 2 goes into saturation so that the gain control section 3 cannot correctly recognize a magnitude of the analog input signal x₀. Thus, there is a problem that it takes time in making proper the gain of the variable-gain amplifier 1.

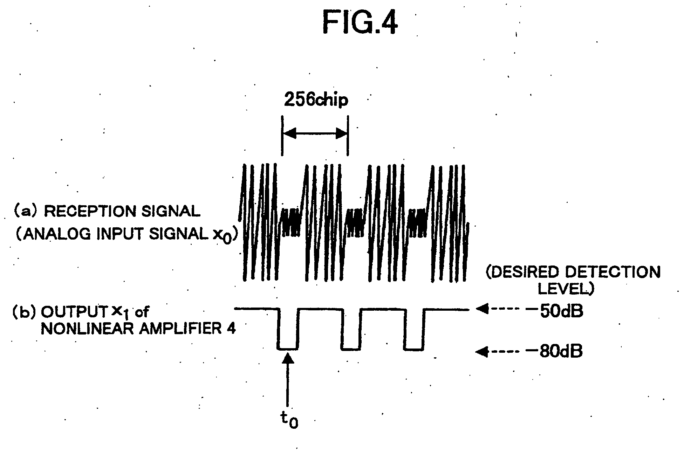

Consequently, it is a general practice to use an amplifying device as shown in Fig. 2. In the figure, the identical and corresponding elements to those of Fig. 1 are attached with the same references and omittedly explained. In Fig. 2, 4 is a nonlinear amplifier, 21 is a first A/D converter, and 22 is a second A/D converter. The nonlinear amplifier 4 generally in many cases uses a logarithmic amplifier.

Now the operation will be explained. The nonlinear amplifier 4 nonlinearly amplifies the analog input signal x₀ to thereby nonlinearly compress the amplitude of the analog input signal x₀, and outputs it to the second A/D converter 22. The second A/D converter 22 A/D-converts the amplitude-compressed signal and outputs it to the gain control section 3. The gain control section 3 recognizes the magnitude of analog input signal x0 on the basis of the output of the second A/D converter 22 and controls the gain in variable-gain amplifier 1. The analog input signal x₀, amplified to a magnitude suited for A/D conversion in the variable-gain amplifier 1, is A/D-converted in the first A/D converter 21 and outputted.

Because the amplifying device shown in Fig. 2 is configured as in the above, the signal to be inputted to the second A/D converter 22 will not exceed in magnitude the conversion capability of the second A/D converter 22. The gain control section 3 is allowed to detect a magnitude of the analog input signal x₀ at all times. Accordingly, it is possible to swiftly, properly set a gain of the variable gain amplifier 1 as compared to the device shown in Fig. 1.

However, in the amplifying devices shown in Figs. 1 and 2, there has been a problem that, in case noise is contained in the analog input signal x₀, the gain control section 3 follows the noise to excessively vary the gain in the variable-gain amplifier 1.

Particularly, in the case of A/D-conversion of a reception signal in CDMA communication, because the input signal is a resultant wave of the signals spread in different spread-spectrum code sequences, the amplitude of the resultant wave varies periodically or nonperiodically. There has been a problem that the gain of the variable-gain amplifier 1 cannot be properly set.

The present invention has been made in order to solve the above problem. It is an object to provide an amplifying device capable of carrying out A/D conversion with high accuracy even where noise is contained in the analog signal, and a receiver using the amplifying device.

### DISCLOSURE OF THE INVENTION

An amplifying device according to the invention comprises variable-gain amplifying means for amplifying and outputting an analog signal, detecting means for detecting a signal level of the analog signal, selecting means for selecting a relatively great signal level from the signal levels detected by the detecting means, and gain control means for controlling the gain in the variable-gain amplifying means on the basis of the signal level selected by the selecting means, thus making possible to properly A/D-convert an analog input signal containing noise. Meanwhile, a receiver according to the invention is provided with the amplifying device to A/D-convert a reception signal, thus making possible to properly A/D-convert a reception signal containing noise.

### BRIEF DESCRIPTION OF THE DRAWINGS

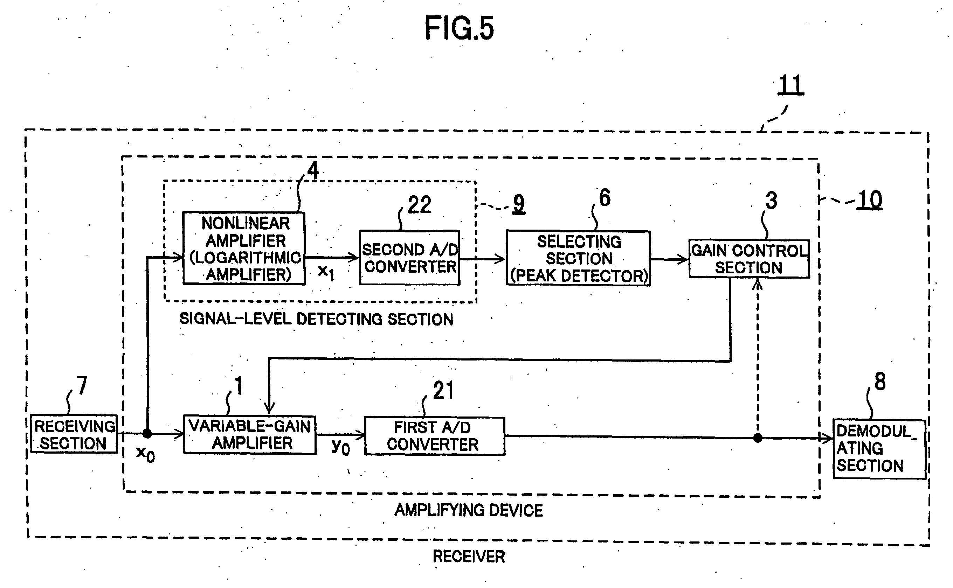

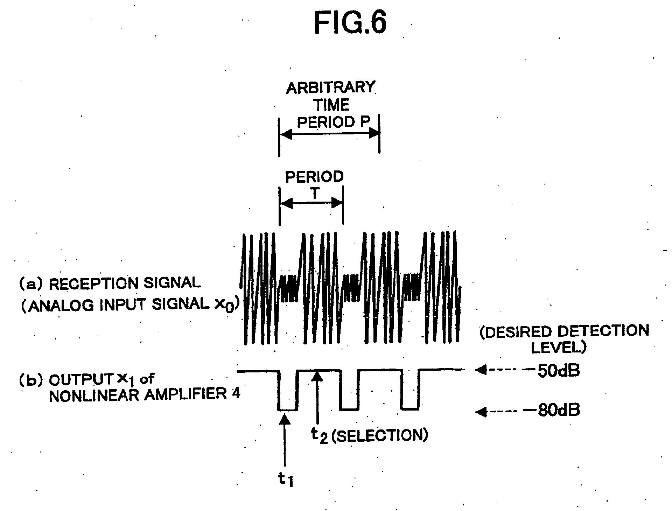

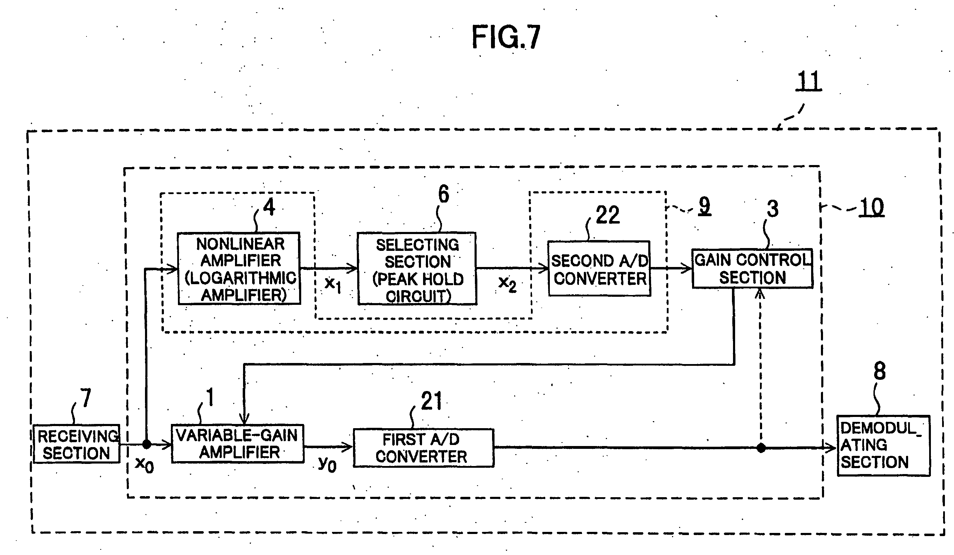

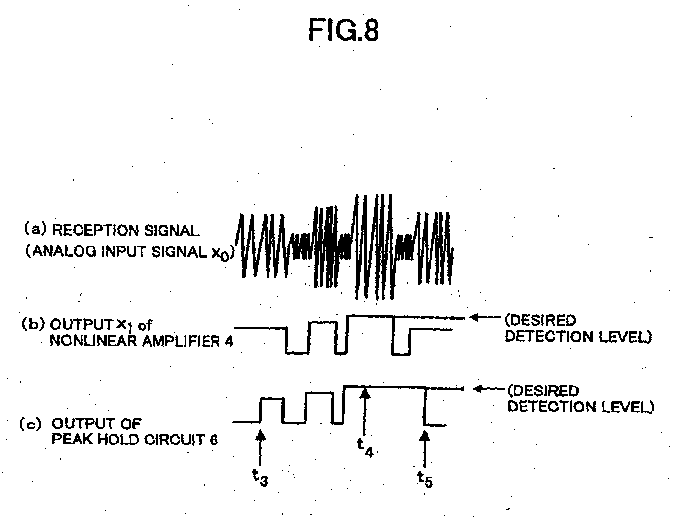

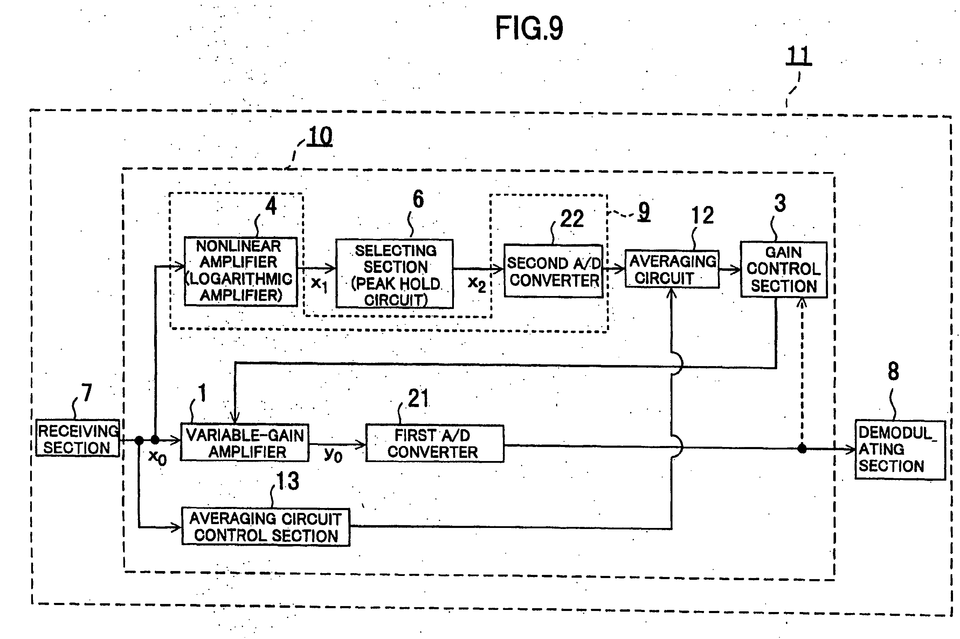

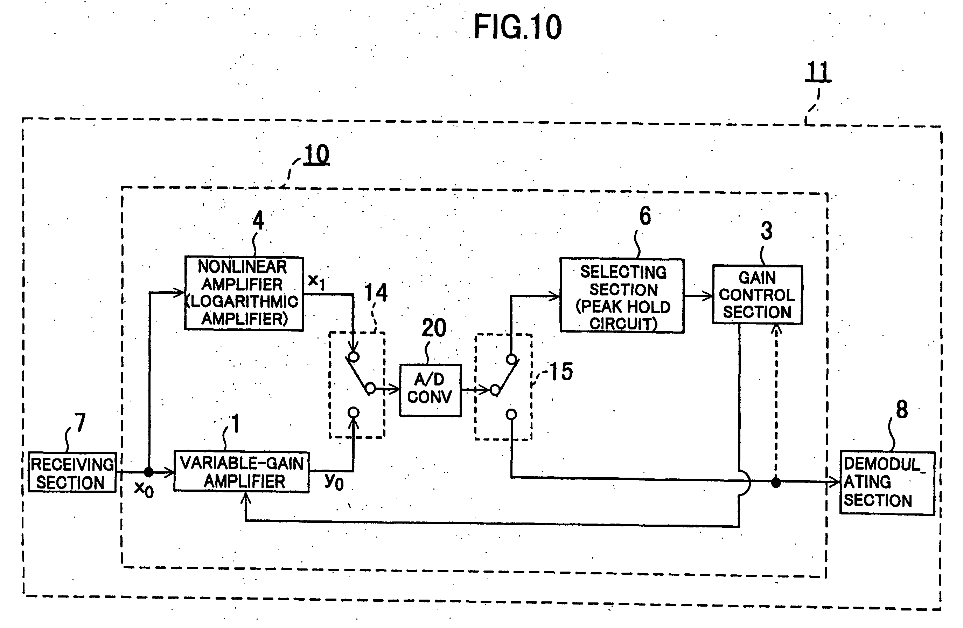

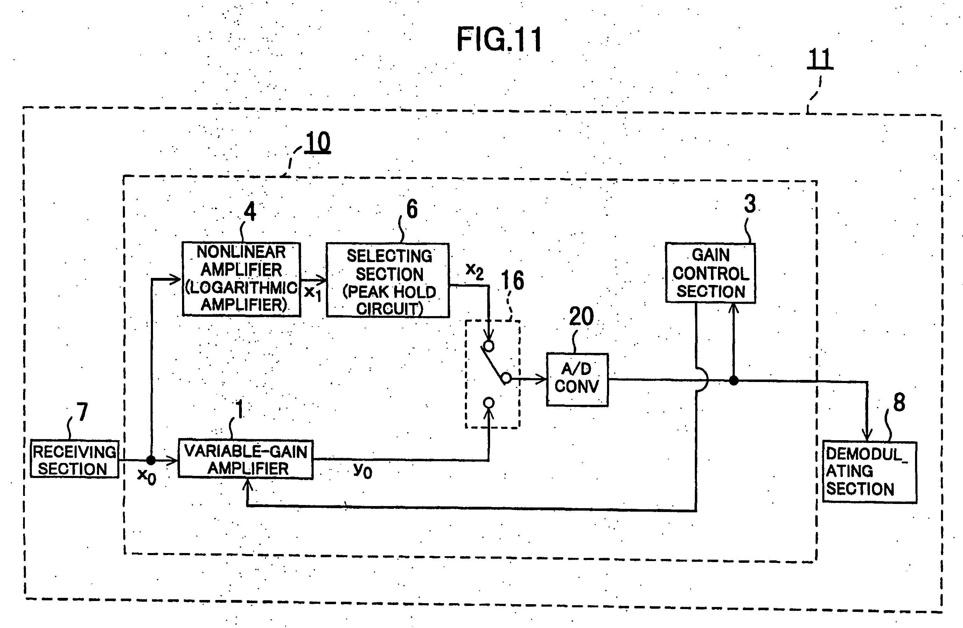

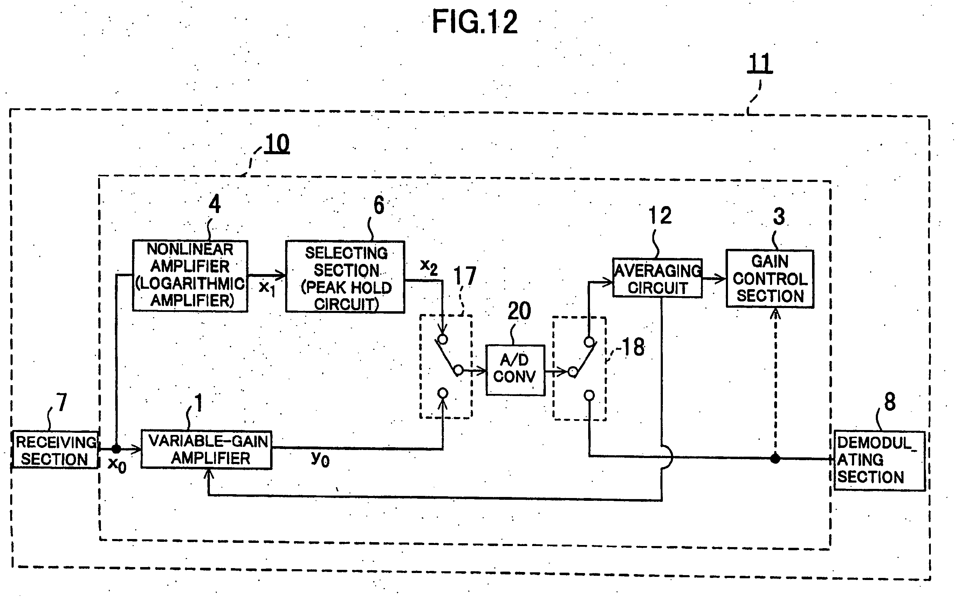

Fig. 1 is a schematic configuration diagram exemplifying a conventional amplifying device. Fig. 2 is a schematic configuration diagram exemplifying another conventional amplifying device. Fig. 3 is a schematic configuration diagram exemplifying an amplifying device having an averaging circuit. Fig. 4 is an explanatory diagram exemplifying the operation of the amplifying device shown in Fig. 3. Fig. 5 is a schematic configuration diagram exemplifying an amplifying device and receiver of embodiment 1. Fig. 6 is an explanatory diagram exemplifying the operation of the amplifying device and receiver shown in Fig. 5. Fig. 7 is a schematic configuration diagram exemplifying an amplifying device and receiver of embodiment 2. Fig. 8 is an explanatory diagram exemplifying the operation of the amplifying device and receiver shown in Fig. 7. Fig. 9 is a schematic configuration diagram exemplifying an amplifying device and receiver of embodiment 3. Fig. 10 is a schematic configuration diagram exemplifying an amplifying device and receiver of embodiment 4. Fig. 11 is a schematic configuration diagram exemplifying an amplifying device and receiver of embodiment 5. Fig. 12 is a schematic configuration diagram exemplifying an amplifying device and receiver of embodiment 6.

### BEST MODE FOR CARRYING OUT THE INVENTION

In the case that the analog input signal contains noise, the accuracy of A/D conversion can be improved by the use of an amplifying device, for example, as shown in Fig. 3. In Fig. 3, the identical or corresponding elements to those of Fig. 2 are denoted with the same references and omittedly explained. In Fig. 3, 5 is an averaging circuit. A nonlinear amplifier 4 logarithmically amplifies and outputs an analog input signal x₀ to a second A/D converter 22. The second A/D converter 22 A/D-converts and outputs the input signal to the averaging circuit 5. The averaging circuit 5 takes an average in time and outputs the output of the second A/D converter 22 to a gain control section 3. The gain controller 3 controls a gain of a variable-gain amplifier 1 on the basis of the output of the second A/D converter 22.

In this manner, in the device shown in Fig. 3, the noise component contained in the input signal is removed by the averaging circuit 5. However, because of averaging after the nonlinear amplification (logarithmic amplification) of the analog input signal x₀, there is a problem that a true average value is not obtainable.

In particular, where the analog input signal x₀ is a reception signal in WCDMA communication, the relevant analog input signal x₀ is a multiplex of a plurality of signals spread in different spread-spectrum code sequences. Consequently, there is great variation in signal level with a period longer than the 1-chip period, with a result that the average value operated in the averaging circuit 5 likely deviates from a true average value.

For example, according to the experiment conducted for the invention, the reception signal level in WCDMA communication greatly varies with a period of approximately 256 chips (= 1/10 slot, approximately 67 µs). Fig. 4 is a schematic explanatory diagram schematically explaining a result of the experiment. In the figure, Fig. 4(a) shows a reception signal waveform in WCDMA communication while Fig. 4(b) shows an output waveform of the nonlinear amplifier in the case the reception signal is inputted to the device shown in Fig. 3. As shown in Fig. 4 (a), the reception signal level is in great variation with a period of 256 chips at between -50 dBm and -80 dBm. In case the reception signal shown in Fig. 4(a) is inputted to the amplifying device shown in Fig. 3, the average value obtainable by the averaging circuit 5 is -65 dBm that is different from -53 dBm (= -50 dBm - 3 dBm) as the true average value.

Incidentally, Fig. 4 is the exemplification of a reception signal under WCDMA communication, which reception signal contains a CPICH signal and a P - CCPCH signal. The CPICH and P-CCPCH are control channels to be used in WCDMA communication. These have been spread by a spread-spectrum code sequence shown in the below table. Note that, in the below table, Tc is a chip period.

| | | | | | | | | | | |
|---|---|---|---|---|---|---|---|---|---|---|
| Tc | 0 | 1 | ... | 126 | 127 | 128 | 129 | ... | 254 | 255 |
| CPICH | 0 | 0 | ... | 0 | 0 | 0 | 0 | ... | 0 | 0 |
| P-CCPCH | 0 | 0 | ... | 0 | 0 | 1 | 1 | ... | 1 | 1 |

In this manner, CPICH is "0" in all the spread-spectrum codes in a period Tc = 0 - 255, while P-CCPCH is "0" in all the spread-spectrum codes in a period Tc = 0 - 127 and "1" in all the spread-spectrum codes in a period Tc = 128 - 255. Consequently, if combining the channels, the both are intensified with each other in the period Tc = 0 - 127 but the both are canceled with each other in the period Tc = 128 - 255.

Usually, as the spread-spectrum code sequence, a linearly independent one free from interference with another spread-spectrum code sequence is selected. However, it is nothing more than the ideal, actually it is a practice to use, at the same time, a plurality of spread-spectrum code sequences that are to interfere one with another as in the above CPICH and P-CCPCH. Consequently, in the actual, reception signal is observed an amplitude variation to be considered resulting from the interference between spread-spectrum code sequences.

Note that 1 chip means 1 spread-spectrum code and 1-chip period is a period corresponding to 1 spread-spectrum code. Meanwhile, the reception signal to be received in CDMA communication is a digital modulation wave having a varying instantaneous amplitude. Also, although a linear amplifier can be used in place of the nonlinear amplifier 4 shown in Fig. 2, dynamic range can be readily secured rather by the use of a nonlinear amplifier.

### Embodiment 1

The present invention is configured as shown in Fig. 5, in view of the above situation. Note that Fig. 5 is a configuration diagram exemplifying a receiver built with the amplifying device of the present embodiment 1. In the figure, 11 is a receiver which is configured with a receiving section 7, an amplifying device 10 and a demodulating section 8. The amplifying device 10 is configured with a signal-level detecting section 9, a selector section 6, a gain control section 3, a variable-gain amplifier 1 and a first A/D converter 21. The signal-level detecting section 9 is configured with a nonlinear amplifier 4 and a second A/D converter 22. Herein, the nonlinear amplifier 4 is for example a logarithmic amplifier while the selector section 6 is for example a peak detector.

The operation of the receiver 11 will be schematically explained. The signal-level detecting section 9 detects a signal level of a reception signal x₀ to be inputted to the variable-gain amplifier 1 and outputs it to the selecting section 6. The selecting section 6 selects a relatively great signal level from among a plurality of signal levels detected by the signal level detecting section 9, and outputs it to the gain control section 3. Particularly, in the present embodiment 1, the selecting section 6 selects a greatest signal level from among a plurality of signal levels detected by the signal level detecting section 9, and outputs it to the gain control section 3. The gain control section 3 controls the gain of the variable gain amplifier 1, on the basis of the signal level selected by the selecting section 6. The variable-gain amplifier 1 amplifies, by the gain controlled by the gain control section 3, the reception signal x₀ received by the receiving section 7, and outputs it to the first A/D converter 21. The first A/D converter 21 A/D-converts and output an output y₀ of the variable-gain amplifier 1 to the demodulating section 8.

More specifically, the nonlinear amplifier 4 shown in Fig. 5 is for example a logarithmic amplifier, which outputs a direct-current voltage x₁ corresponding to the signal level of the reception signal x₀. The second A/D converter 22 A/D-converts and outputs the direct-current voltage x₁ outputted by the nonlinear amplifier 4 to the selector section 6. The selector section 6 herein is a peak detector, which detects a maximum signal level within a predetermined period of the reception signal x₀ from the output of the second A/D converter 22 and outputs a detection result to the gain control section 3. The gain control section 3 controls the gain of the variable-gain amplifier 1 on the basis of the result of detection by the selecting section 6.

Fig. 6 is an explanatory diagram exemplifying the operations of the nonlinear amplifier 4, second A/D converter 22 and selector section 6 shown in Fig. 5. In Fig. 6, Fig. 6(a) is a waveform of the reception signal x₀ and Fig. 6(b) is a waveform of a direct-current voltage x₁ outputted by the logarithmic amplifier as the nonlinear amplifier 4, wherein t1 and t2 are sampling timings by the second A/D converter 22 and T is a period of the reception signal x₀. Herein, the selector section 6 selects and outputs a greater value of the values obtained by the sampling at time t1 and t2 to the gain control section 3 shown in Fig. 5.

More specifically, in Fig. 6, the second A/D converter 22 and the selector section 6 operate satisfying the following conditions 1) - 3).
1) The second A/D converter 22 carries out sampling a plurality of number of times within an arbitrary period P.
2) The peak detector 6 selects a maximum value from a plurality of values sampled within the period P.
3) In the case the signal level of reception signal x₀ varies with a period T, the second A/D converter 22 conducts sampling at least twice at a time interval other than integer times of the relevant period T within the relevant period P. For example, the second A/D converter 22 conducts sampling at a sampling interval of (T/n + mT). Herein, T is a period of a reception signal, n is the number of times of sampling (n ≠ 1) and m is an arbitrary integer equal to or greater than 0.

Note that the period P has an arbitrary time width. However, because the reception signal received in CDMA communication varies with one period of at least 1-chip period, the relevant period P is preferably given a longer time width than the 1-chip period. Also, because the signal to be received under CDMA communication tends to vary with a period of approximately 256-chip periods, the second A/D converter 22 preferably conducts sampling, within the period P, at least twice at a time interval other than integer times of the 256-chip periods.

As in the above, according to the present embodiment 1, because the gain of the variable-gain amplifier 1 is controlled on the basis of the maximum signal level of the reception signal x₀ inputted to the variable-gain amplifier 1. Accordingly, even where the signal level of the reception signal x₀ is varied due to interference with other signals or the like, the gain of the variable-gain amplifier 1 can be properly controlled.

Incidentally, although, in Fig. 5, the reception signal x₀ before input to the variable-gain amplifier 1 was inputted to the signal-level detector 9, the output y₀ of the variable-gain amplifier 1 may be inputted to the signal-level detector 9.

Also, although, in Fig. 5, the selector section 6 selected a greatest signal level from among the signal levels detected in the signal-level detector 9, how to select is by any way provided that a relatively great signal level is selected from the detected signal levels. For example, a second greatest signal level may be selected from the detected signal levels, or otherwise, a greatest signal level which is smaller than a predetermined value may be selected from the detected signal levels.

Meanwhile, the gain control section 3 shown in Fig. 5 may control the gain of the variable-gain amplifier 1 on the basis of the both outputs of the selector section 6 and the first A/D converter 21. For example, in the initial stage of reception, the gain of the variable-gain amplifier 1 may be controlled on the basis of an output of the selector section 6 to within a range the output of first A/D converter 21 does not go into saturation, and thereafter the gain of variable-gain amplifier 1 be controlled with accuracy on the basis of an output of the first A/D converter 21.

### Embodiment 2

Although the amplifying device of embodiment 1 provided the selector section 6 in a stage ofter the second A/D converter 22 as shown in Fig. 5, the selector section 6 may be provided in a stage before the second A/D converter 22 as shown in the present embodiment 2.

Fig. 7 is a configuration diagram exemplifying a receiver including an amplifying device of the present embodiment 2. In the figure, the identical or corresponding elements those of to Fig. 5 are attached with the same references and omittedly explained. Herein, the selector section 6 shown in Fig. 5 is arranged between the nonlinear amplifier 4 and the second A/D converter 22 whereby a peak-hold circuit is used as the selector section 6. The operation will be explained. The nonlinear amplifier 4 outputs a direct-current voltage x₁ corresponding to a signal level of the reception signal x₀. The peak hold circuit, as selector section 6, continues to output a maximum voltage x₂ within a predetermined period of the direct-current voltage x₁. The second A/D converter 22 A/D-converts and outputs the maximum voltage x₂ outputted by the selector section 6 to the gain-control circuit 3. The gain-control circuit 3 controls the gain in the variable-gain amplifier 1 on the basis of a digital value outputted by the second A/D converter 22.

Fig. 8 is an explanatory diagram exemplifying the operations of the logarithmic amplifier as the nonlinear amplifier 4 shown in Fig. 7, the peak hold circuit as the selector section 6 and the second A/D converter 22. In the figure, Fig. 8(a) is a waveform of a reception signal x₀ to be inputted to the nonlinear amplifier 4, Fig. 8(b) is a waveform of a direct-current voltage x₁ outputted by the logarithmic amplifier 4, and Fig. 8(c) is an output waveform of the peak hold circuit 6, wherein t3 is an operation start time point of the peak hold circuit 6, t4 is a sample timing of the second A/D converter 22, and t5 is an operation end time point of the peak hold circuit 6. Herein, the second A/D converter 22 samples (t4) an output of the peak hold circuit 6 at least once within the peak holding (period t3 - t5) of the peak hold circuit 6 and outputs it to the gain control section 3.

### Embodiment 3

Fig. 9 is a configuration diagram exemplifying a receiver including an amplifying device of the present embodiment 3. In the figure, the identical or corresponding elements to those of Fig. 7 are attached with the same references and omittedly explained. Herein, an averaging circuit 12 is provided in a stage ofter the second A/D converter 22. Meanwhile, 13 is an averaging-circuit control section. The operation will be explained. The nonlinear amplifier 4 outputs a direct-current voltage x₁ corresponding to a signal level of the reception signal x₀. The selector section 6 continues to output a maximum voltage x₂ of the direct-current voltage x₁ within a predetermined period. The second A/D converter 22 converts the maximum voltage x₂ outputted by the selector section 6 into a digital value and outputs it to the averaging circuit 12. The averaging circuit 12 operates an average value of the digital values outputted by the second A/D converter 22 and outputs it to the gain control section 3. The gain control section 3 controls the gain in the variable-gain amplifier 1 on the basis of the operated average value.

Meanwhile, the averaging-circuit control section 13 increases or decreases the modulus of averaging in averaging circuit 2, depending on a state of the reception signal x₀. Namely, the averaging circuit 12 controls the number of values to be averaged in the averaging circuit 12, depending on a propagation status of the radio wave received by the receiving section 7. For example, in the case the reception signal x₀ has a long fading period, the number of digital values to be used in one averaging operation is increased. In the case the reception signal x₀ has a short fading period, the number of the digital values is decreased.

As in the above, according to the embodiment 3, relatively great signal levels are selected, in plurality from among the signal levels of the reception signal x₀ inputted to the variable-gain amplifier 1, and the gain of the variable-gain amplifier 1 is controlled on the basis of an average value of the selected signal levels. Accordingly, even where the signal level of reception signal x₀ varies due to noise or the like, the gain of the variable-gain amplifier 1 can be properly controlled. Also, because the number of the values to be averaged is increased and decreased depending upon a length of fading period of reception signal x₀, the gain of the variable-gain amplifier 1 can be further, properly controlled.

### Embodiment 4

In the present embodiment 4, the nonlinear amplifier 4 and variable-gain amplifier 1 shown in Fig. 5 commonly use an A/D converter as a destination of output. Fig. 10 is a configuration diagram exemplifying a receiver including an amplifying device of the present embodiment 4. In the figure, the identical or corresponding elements to those of Fig. 5 are attached with the same references and omittedly explained. Herein, switches 14 and 15 are respectively provided at the stages before and after the A/D converter 20. By associatively operating the switches 14 and 15, switching-over is made between a first route passing the nonlinear amplifier 4, A/D converter 20 and selector part 6 and reaching the gain control section 3 and a second route passing the variable-gain amplifier 1 and A/D converter 20 and reaching the gain control section 3 and demodulating section 8.

Now the operation will be explained. First, the switch 14 and switch 15 is controlled to form a first route passing the nonlinear amplifier 4, A/D converter 20 and selector section 6. At this time, the nonlinear amplifier 4 outputs a direct-current voltage x₁ commensurate with a signal level of the reception signal x₀. The A/D converter 20 converts this direct-current voltage x₁ into a digital value and outputs it to the selector section 6. The selector section 6 detects a maximum value from the digital values and outputs it to the gain control section 3. The gain control section 3 controls the gain of the variable-gain amplifier 1 on the basis of the maximum value selected by the selector section 6.

Subsequently, the switch 14 and the switch 15 are changed over to form a second route passing the variable-gain amplifier 1 and A/D converter 20 and reaching the gain control section 3 and demodulating section 8. At this time, the variable-gain amplifier 1 amplifies and outputs the reception signal x₀ to the A/D converter 20. The A/D converter 20 converts the input signal into a digital value and outputs it to the gain-control section 3 and demodulating section 8. The gain control section 3 controls the gain of the variable-gain amplifier 1 on the basis of the digital value inputted from the A/D converter 20, while the demodulating section 8 demodulates the digital value inputted from the A/D converter 20.

As in the above, in the present embodiment 4, because the first A/D converter for A/D-converting an output of the variable-gain amplifier 1 and the second A/D converter for A/D-converting an output of the nonlinear amplifier 4 are used commonly, the amplifying device can be size-reduced.

### Embodiment 5

In the present embodiment 5, the selector section 6 and the variable-gain amplifier 1, shown in Fig. 7, are used commonly with an A/D converter as a destination of output. Fig. 11 is a configuration diagram exemplifying a receiver including an amplifying device of the present embodiment 5. In the figure, the identical or corresponding elements to those of Fig. 7 are attached with the same references and omittedly explained. Herein, a switch 16 is provided in a stage before the A/D converter 20. By changing over the switch 16, an output x₂ of the peak hold circuit 6 and an output y₀ of the variable-gain amplifier 1 are inputted, with switching, to the A/D converter 20. Meanwhile, an output of the A/D converter 20 is outputted to the gain control section 3 and the demodulator 8.

Now the operation will be explained. First, the switch 16 is controlled to connect between the peak hold circuit 6 and the A/D converter 20. At this time, the nonlinear amplifier 4 outputs a direct-current voltage x₁ commensurate with a signal level of the reception signal x₀ so that the peak hold circuit 6 continues to output a maximum voltage x₂ of the direct-current voltage x₁ within a predetermined period. The A/D converter 20 converts the direct-current voltage x₂ outputted by the peak hold circuit 6 into a digital value and outputs the digital value to the gain control section 3 and demodulator section 8. The gain control section 3 controls the gain of the variable-gain amplifier 1 on the basis of the digital value inputted by the A/D converter 20. At this time, it is arbitrary, in the demodulating section 8, whether to demodulate the output of the A/D converter 20 or not.

Subsequently, the switch 16 is changed over to connect between the variable-gain amplifier 1 and the A/D converter 20. At this time, the variable-gain amplifier 1 amplifies the reception signal received in the receiving section 7 and output it to the A/D amplifier 20. The A/D converter 20 A/D-converts and outputs the output of the variable-gain amplifier 1 to the gain control section 3 and demodulating section. The gain control section 3 controls the gain of the variable-gain amplifier 1 on the basis of the digital value inputted from the A/D converter 20 while the demodulating section 8 demodulates the digital value inputted by the A/D converter 20.

As in the above, in the present embodiment 5, because the first A/D converter for converting an output of the variable-gain amplifier 1 and the second A/D converter for A/D-converting an output of the peak hold circuit 6 are used commonly, the amplifying device can be size-reduced.

### Embodiment 6

In the present embodiment 6, the selector section 6 and the variable-gain amplifier 1, shown in Fig. 9, are used commonly with an A/D converter as a destination of output. Fig. 12 is a configuration diagram exemplifying a receiver including an amplifying device of the present embodiment 6. In the figure, the identical or corresponding elements to those of Fig. 9 are attached with the same references and omittedly explained. Herein, a switch 17 and a switch 18 are associatively operated to switch over between a first route passing the nonlinear amplifier 4, peak hold circuit 6, A/D converter 20 and averaging circuit 12 and reaching the gain control section 3 and a second route passing the variable-gain amplifier 1 and A/D converter 20 and reaching the gain control section 3 and demodulating section 3.

The operation will be explained. First, the switch 17 and the switch 18 are controlled to form a first route passing the nonlinear amplifier 4, peak hold circuit 6, A/D converter 20 and averaging circuit 12. At this time, the nonlinear amplifier 4 outputs a direct-current voltage x₁ commensurate with a signal level of the reception signal x₀ so that the peak hold circuit 6 continues to output a maximum voltage x₂ of the direct-current voltage x₁ within a predetermined period. The A/D converter 20 converts the direct-current voltage x₂ outputted by the peak hold circuit 6 into a digital value and outputs the digital value to the averaging circuit 12. The averaging circuit 12 operates an average value of a plurality of digital values outputted by the A/D converter 20, and the gain control section 3 controls the gain of the variable-gain amplifier 1 on the basis of the operated average value.

Subsequently, the switch 17 and the switch 18 are changed over to form a second route passing the variable-gain amplifier 1 and A/D converter 20 and reaching the gain control section 3 and demodulating section 3. At this time, the variable-gain amplifier 1 amplifies and outputs the reception signal x₀ to the A/D amplifier 20. The A/D converter 20 converts an input signal into a digital value and outputs it to the gain control section 3 and demodulating section 8. The gain control section 3 controls the gain of the variable-gain amplifier 1 on the basis of the digital value inputted from the A/D converter 20 while the demodulating section 8 demodulates the digital value inputted from the A/D converter 20.

As in the above, in the present embodiment 6, because the first A/D converter for converting an output of the variable-gain amplifier 1 and the second A/D converter for A/D-converting an output of the peak hold circuit 6 are used commonly, the amplifying device can be size-reduced.

## Claims

1. An amplifying device comprising:
variable-gain amplifying means for amplifying and outputting an analog input signal;
detecting means for detecting a signal level of the analog input signal;
selecting means for selecting a relatively great signal level from the signal levels detected by the detecting means; and
gain control means for controlling the gain in the variable-gain amplifying means on the basis of the signal level selected by the selecting means.

2. An amplifying device according to claim 1, wherein a greatest signal level is selected from the signal levels detected by the detecting means.

3. An amplifying device according to claim 1, wherein the selecting means selects a relatively great signal level from the signal levels detected by the detecting means on the basis in a magnitude order of the signal levels.

4. An amplifying device according to claim 1, wherein a greatest level which is smaller than a predetermined level is selected from the signal levels detected by the detecting means.

5. An amplifying device according to claim 1, wherein the selecting means selects a plurality of relatively great signal levels from the signal levels detected by the detecting means, and
further comprises averaging means for averaging the plurality of signal levels selected,
the gain control means controlling the gain in the variable-gain amplifying means on the basis of a signal level averaged by the averaging means.

6. An amplifying device according to claim 5, further comprising averaging control means for controlling the number of signal levels to be averaged by the control means, according to a status of the analog input signal.

7. An amplifying device according to claim 1, wherein the variable-gain amplifying means amplifies and outputs the analog input signal to a first A/D converter,
the detecting means being nonlinear amplifying means having an output voltage varying according to a signal level of the analog input signal, and
further comprising a second A/D converter for A/D-converting and outputting an output voltage of the nonlinear amplifying means,
the selecting means selecting a relatively great value from the digital values outputted by the second A/D converter, and
the gain control means controlling the gain in the variable-gain amplifying means on the basis of a digital value selected by the selecting means.

8. An amplifying device according to claim 1, wherein the variable-gain amplifying means amplifies and outputs the analog input signal to a first A/D converter,
the detecting means being nonlinear amplifying means having an output voltage varying according to a signal level of the analog input signal,
the selecting means selecting a relatively great voltage from output voltages of the nonlinear amplifying means and continuing to output the selected voltage,
further comprising a second A/D converter for A/D-converting and outputting an output voltage of the nonlinear amplifying means,
the gain control means controlling the gain in the variable-gain amplifying means on the basis of a digital value outputted by the second A/D converter.

9. An amplifying device according to claim 1, wherein the variable-gain amplifying means amplifies and outputs the analog input signal to a first A/D converter,
the detecting means being nonlinear amplifying means having an output voltage varying according to a signal level of the analog input signal,
the selecting means selecting a relatively great voltage from output voltages of the nonlinear amplifying means and continuing to output the selected voltage,
further comprising a second A/D converter for A/D-converting and outputting an output voltage of the selecting means and average-value operating means for operating an average value of a plurality of digital values outputted by the second A/D converter,
the gain control means controlling the gain in the variable-gain amplifying means on the basis of an average value operated by the average-value operating means.

10. An amplifying device according to claim 1, wherein the detecting means is nonlinear amplifying means having an output voltage varying nonlinearly according to a signal level of the analog input signal, and
further comprises a first switch for inputting, with changing over to a same A/D converter, an output of the nonlinear amplifying means and an output of the variable-gain amplifying means, and a second switch for associatively operating with the first switch to input, with changing over, an output of the A/D converter to the selecting means and the gain control means,
the selecting means selecting and outputting a relatively great digital value from digital values inputted from the A/D converter to the gain-control means, and
the gain control means controlling the gain in the variable-gain amplifying means on the basis of a digital value inputted by the A/D converter or selecting means.

11. An amplifying device according to claim 1, wherein the detecting means is nonlinear amplifying means having an output voltage varying according to a signal level of the analog signal,
the selecting means selecting a relatively great voltage from output voltages of the nonlinear amplifying means and continuing to output the selected voltage,
further comprising a A/D converter for A/D-converting and outputting an output voltage of the selecting means and an output of the variable-gain amplifying means,
the variable-gain amplifying means controlling the gain in the variable-gain amplifying means on the basis of a digital value inputted from the A/D converter.

12. An amplifying device according to claim 1, wherein the detecting means is nonlinear amplifying means having an output voltage varying nonlinearly according to a signal level of the analog input signal,
the selecting means selecting a relatively great voltage from output voltages of the nonlinear amplifying means and continuing to output the selected voltage;
further comprising a first switch for inputting, with changing over, to a same A/D converter an output of the selecting means and an output of the variable-gain amplifying means, and a second switch for associatively operating with the first switch to input, with changing over, an output of the A/D converter to average-value operating means for operating an average value of digital values outputted by the A/D converter and to the gain control means,
the gain control means controlling the gain in the variable-gain amplifying means on the basis of an output of the A/D converter or an operating result of the average-value operating means.

13. A receiver comprising:
variable-gain amplifying means for amplifying and outputting an analog input signal received by radio communication;
an A/D converter for A/D-converting an output of the variable-gain amplifying means;
demodulating means for demodulating a digital signal outputted by the A/D converter;
detecting means for detecting a signal level of the received analog signal;
selecting means for selecting a relatively great signal from signal levels outputted by the detecting means; and
gain control means for control a gain in the variable-gain amplifying means on the basis of a signal level selected by the selecting means.

14. A receiver according to claim 13, wherein the received analog signal is a digital modulation wave varying in instantaneous amplitude.

15. A receiver according to claim 13, wherein the received analog signal is a spread-spectrum modulated signal by using a spread-spectrum code sequence of a plurality of chips;
the selecting means selecting a relatively great signal level from signal levels detected within a period longer than a 1-chip period by the detecting means.

16. A receiver according to claim 13, wherein the detecting means, in the case the signal level of the received analog signal varies with a period T, detects a signal level at least twice at a time interval other than integer times the period T,
the selecting means selecting a relatively great signal level from detected signal levels.

17. A receiver according to claim 13, wherein the selecting means selecting a plurality of relatively great signal levels from the signal levels detected by the detecting means,
further comprising an average-value operating means for operating an average value of the plurality of signal levels selected,
the gain control means controlling a gain in the variable-gain amplifying means on the basis of an average value operated by the average-value operating means,
further comprising averaging control means for controlling a modulus of averaging operation in the average-value operating means according to a fading state of the received analog signal.

18. A receiver comprising:
variable-gain amplifying means for amplifying and outputting a CDMA reception signal received by radio communication;
an A/D converter for A/D-converting an output amplified by the variable-gain amplifying means;
demodulating means for demodulating a digital signal outputted by the A/D converter;
nonlinear amplifying means for nonlinearly amplifying and outputting the CDMA reception signal;
selecting means for selecting a relatively great signal level from signal levels outputted by the nonlinear amplifying means; and
gain control means for controlling a gain in the variable-gain amplifying means on the basis of a signal level selected by the selecting means.

19. A receiver comprising:
variable-gain amplifying means for amplifying and outputting a CDMA reception signal received by radio communication;
an A/D converter for A/D-converting an output amplified by the variable-gain amplifying means;
demodulating means for demodulating a digital signal outputted by the A/D converter;
nonlinear amplifying means for nonlinearly amplifying and outputting the CDMA reception signal;
selecting means for selecting a relatively great signal level from signal levels outputted by the nonlinear amplifying means; and
gain control means, in an initial stage of receiving a CMA reception signal, for controlling a gain in the variable-gain amplifying means on the basis of a signal level selected by the selecting means and, after the initial stage of reception, for controlling a gain of the variable-gain amplifying means on the basis of an output of the A/D converter.

20. A receiver according to claim 18 or 19, wherein the CDMA reception signal contains CPICH and P-CCPCH signals.
